(19) Europäisches Patentamt / European Patent Office / Office européen des brevets

(11) **EP 4 030 622 B1**

(12) **EUROPÄISCHE PATENTSCHRIFT**

(45) Veröffentlichungstag und Bekanntmachung des Hinweises auf die Patenterteilung:
**01.07.2026  Patentblatt 2026/27**

(21) Anmeldenummer: **22000002.0**

(22) Anmeldetag: **04.01.2022**

(51) Internationale Patentklassifikation (IPC):
**H03K 17/95** (2006.01)    **G01B 7/02** (2006.01)

(52) Gemeinsame Patentklassifikation (CPC):
**H03K 17/952; H03K 17/9502**

(54) **INDUKTIVE ANNÄHERUNGSSENSOREINHEIT UND VERFAHREN ZUR STÖRUNGSÜBERPRÜFUNG BEI EINER INDUKTIVEN ANNÄHERUNGSSENSOREINHEIT**

INDUCTIVE PROXIMITY SENSOR UNIT AND METHOD FOR ERROR CHECKING IN AN INDUCTIVE PROXIMITY SENSOR UNIT

UNITÉ INDUCTIVE DE DÉTECTION DE PROXIMITÉ ET PROCÉDÉ DE DÉTECTION DES DYSFONCTIONNEMENTS DE L'UNITÉ INDUCTIVE DE DÉTECTION DE PROXIMITÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **15.01.2021  DE 102021000157**

(43) Veröffentlichungstag der Anmeldung:
**20.07.2022  Patentblatt 2022/29**

(73) Patentinhaber: **Pepperl+Fuchs SE**
**68307 Mannheim (DE)**

(72) Erfinder: **Braunsmann, Christoph**
**68307 Mannheim (DE)**

(74) Vertreter: **Koch Müller**
**Patentanwaltsgesellschaft mbH**
**Maaßstraße 32/1**
**69123 Heidelberg (DE)**

(56) Entgegenhaltungen:
**CN-A- 106 767 952    DE-A1- 102017 130 122**

**Beschreibung**

Die Erfindung betrifft eine induktive Annäherungssensoreinheit zum Erfassen eines Erfassungskörpers mit metallischen Eigenschaften und Verfahren zur Störungsüberprüfung bei einer induktiven Annäherungssensoreinheit.

Die CN 106 767 952 A offenbart eine induktive Annäherungssensoreinheit zum Erfassen eines metallische Eigenschaften aufweisenden Erfassungskörpers. An einer Sensorspule, die in einer Reihenschaltung mit einem ohmschen Widerstand und einem Schalttransistor an einer Betriebsspannung liegt, wird mittels des Schalttransistors ein pulsförmiges Signal angelegt und die Impulsantwort an der Spule einer Auswerteeinheit mit einem AD-Wandler zugeführt. Hierzu werden Werte für die Spannung zu mehreren Abtastzeitpunkten dem AD-Wandler zugeführt.

Zuerst wird ein Interferenzkontrollpunkt zu einem Zeitpunkt t2 bestimmt, bei welchem die Impulsantwort nahezu abgeklungen ist, also annähernd mit der Betriebsspannung übereinstimmt. Im Bereich dieses Zeitpunktes t2 werden weitere Abtastpunkte bestimmt und alle Zeitpunkte in t2a, t2b und t2c umbenannt. Die Impulsantwort wird in diesen Zeitpunkten t2a, t2b und t2c abgetastet und die zugehörigen Spannungswerte U2a, U2b und U2c erfasst. Diese Spannungswerte U2a, U2b und U2c werden mit sechs mathematischen Bedingen verglichen und diese Werte verworfen, wenn diese Bedingungen nicht erfüllt werden. In diesem Fall ist die Impulsantwort mit einer Störung beaufschlagt. Im anderen Fall, wenn die Spannungswerte U2a, U2b und U2c die sechs mathematischen Bedingungen erfüllten, wird aus diesen Werten ein Mittelwert gebildet, welcher für die weiteren Berechnungen verwendet wird.

In einem nächsten Schritt wird ein Interferenzkontrollpunkt zu einem Zeitpunkt t1 bestimmt, welcher zeitlich vor dem Zeitpunkt t2 und in der Abklingphase der Impulsantwort liegt. Im Bereich dieses Zeitpunktes t1 werden weitere Abtastpunkte bestimmt und alle Zeitpunkte in t1a, t1b und t1c umbenannt. Die Impulsantwort wird in diesen Zeitpunkten t1a, t1b und t1c abgetastet und die zugehörigen Spannungswerte U1a, U1b und U1c erfasst. Diese Spannungswerte U1a, U1b und U1c werden mit weiteren drei mathematischen Bedingen verglichen und diese Werte verworfen, wenn diese Bedingungen nicht erfüllt werden. In diesem Fall ist die Impulsantwort mit einer Störung beaufschlagt. Im anderen Fall, wenn die Spannungswerte U1a, U1b und U1c die drei mathematischen Bedingungen erfüllten, werden diese Werte für die weiteren Berechnungen verwendet.

Weiterhin wird eine Kalibrierung für niedrige Umgebungstemperaturwerte einerseits und hohe Umgebungstemperaturwerte andererseits der induktiven Annäherungssensoreinheit durchgeführt, indem diese in verschiedenen Abständen als Kalibrierungspunkte zwischen 0 mm und 7 mm zum Erfassungskörper gebracht wird und für jeden dieser Kalibrierungspunkte in Abtastzeitpunkten t1a, t1b und t1c die Spannungswerte U1aLi, U1bLi und U1cLi für niedrige Temperaturwerte bzw. U1aHi, U1bHi und U1cHi für hohe Temperaturwerte erfasst werden, wobei der Index i die Kalibrierungspunkte kennzeichnet. Die in den Zeitpunkten t2 erfassten Spannungswerte werden mit U2L bzw. U2H für niedrige bzw. hohe Temperaturwerte bezeichnet. Aus diesen Spannungswerten werden Faktoren Aai, Abi, Aci und Bai, Bbi und Bci gebildet und zusammen mit den Abständen der Kalibrierungspunkte in einer Kontrollpunkt-Lookup-Tabelle dargestellt und in der Annäherungssensoreinheit gespeichert. Diese Daten werden für die Detektion, Berechnung und Störbeseitigung im Detektionsprozess eingesetzt. Wenn die im betriebsmäßigen Einsatz detektierten Spannungswerte U2a, U2b und U2c sowie die Spannungswerte U1a, U1b und U1c die oben genannten mathematischen Beziehungen erfüllen, werden mit U2x bzw. mit U1ax, U1bx und U1cx bezeichnet. Aus diesen Spannungswerten U2× werden zusammen mit den Faktoren Aai, Abi, Aci und Bai, Bbi und Bci Spannungswerte U1aTi, U1bTi and U1cTi für jeden Kalibrierungspunkt i ermittelt und in einer temporären Lookup-Tabelle abgelegt.

Durch Vergleich der Abtastwerte U1ax, U1bx und U1cx mit Werten aus dieser temporären Lookup-Tabelle wird ein Vergleichswert ermittelt und für jeden Kalibrierungspunkt in den Zeitpunkten t1a, t1b und t1c durch lineare Interpolation jeweils ein Abstandwert D1, Db und Dc aus den Abtastwerten U1ax, U1bx und U1cx sowie entsprechenden Werten aus der temporären Lookup-Tabelle berechnet. Einer dieser berechneten Abstandswerte D1, Db und Dc wird als Detektionsergebnis ausgegeben.

Aus der EP 0 492 029 B1 ist ein induktiver Näherungssensor zur Detektion eines metallischen Objekts mit einer Sensorspule bekannt, wobei die Sensorspule für ein erstes Zeitintervall mit einem Strom beaufschlagt wird und in einem zweiten Zeitintervall die Impulsantwort an der Sensorspule erfasst und ausgewertet wird.

Eine weitere nach dem Pulsauswerteverfahren arbeitende induktive Sensoreinheit ist aus der DE 10 2017 130 122 A1 bekannt, wobei temperaturbedingte Induktivitäts- und Wirkwiderstandsänderungen kompensiert werden. Um eine Änderung der Induktivität und / oder des Wirkwiderstands der Sensorspule zu ermitteln, wird der Strom oder die Spannung an der Sensorspule bereits während des Anregungszeitraums, wenn die Sensorspule mit dem Anregungsstrom beaufschlagt ist, abgetastet. Ermittelte Änderungen werden zur Kompensation eines während des Sperrzeitraums abgetasteten Impulsantwortsignals zur Abstandsermittlung verwendet.

In der DE 195 06 339 A1 werden ein induktiver Sensor und ein Detektionsverfahren für ein metallisches Objekt beschrieben, wobei eine Impulsantwort zu vorgebbaren Zeitpunkten abgetastet wird. Die Abtastwerte werden einer Verknüpfung unterzogen, d.h. es werden entweder mehrere Amplitudenwerte oder Flächenabschnitte unterhalb der Impulsantwortkurve durch Summation und/oder Differenzbildung miteinander verknüpft und das Ergebnis mit entsprechenden Referenzwerten verglichen. Das Verfahren ermöglicht es, sowohl auf Objekteigenschaften, wie beispielsweise Material oder Größe des metallischen Objekts zurückzuschließen als auch äußere Einflüsse bzw. Störungen, z.B. durch eine metallhaltige Umgebung, zu unterdrücken.

Aus der DE 11 2013 006 849 A5 ein weiterer mit Pulsauswertung messender induktiver Sensor bekannt, wobei die Impulsantwort mittels eines künstlichen neuronalen Netzwerks ausgewertet wird, um den Abstand sowie die räumliche Orientierung, die Dicke, Materialeigenschaften oder ähnliche Größen des Zielobjekts zu bestimmen.

Die DE 10 2018 127 157 B3 beschreibt einen induktiven Näherungsschalter mit gepulster Stromquelle, wobei der Näherungsschalter dazu ausgelegt ist, in einem sich an das Erfassen einer Impulsantwort anschließenden Zeitintervall den Kupferwiderstand der Sensorspule mittels eines zweiten Anregungsstrompulses zu messen, wobei anhand des Spannungsverlaufs der Kupferwiderstandsmessung die Phasenlage benachbarter baugleicher Näherungsschalter ermittelt und eine Synchronisation vorgenommen werden kann. Hierdurch werden störende Einflüsse durch benachbarte Näherungsschalter verhindert.

Aus der DE 10 2011 018 430 A1 ist ein weiterer induktiver Näherungsschalter bekannt, wobei störende Einflüsse durch benachbarte Näherungsschalter durch eine Synchronisation der Taktfrequenzen der Näherungsschalter vermieden werden bzw. die Taktfrequenzen aller schnelleren Näherungsschalter an durch eine interne Verzögerung an die Taktfrequenz des langsamsten Näherungsschalters angepasst werden.

Die EP 3 531 557 A1 beschreibt einen induktiver Näherungsschalter, wobei mittels eines aperiodischen Anregungspulsverlaufs der Einfluss von periodischen Störsignalen reduziert wird. Weitere Näherungsschalter sind aus der DE 195 30 987 C1, der DE 10 2013 209 805 A1 und der DE 10 2009 058 549 A1 bekannt.

Vor diesem Hintergrund besteht die Aufgabe der Erfindung darin, eine Vorrichtung anzugeben, die den Stand der Technik weiterbildet.

Die Aufgabe wird durch eine induktive Annäherungssensoreinheit mit den Merkmalen des Patentanspruchs 1 sowie durch ein Verfahren mit den Merkmalen des Patentanspruchs 5 gelöst. Vorteilhafte Ausgestaltungen der Erfindung sind Gegenstand von Unteransprüchen.

Gemäß dem Gegenstand der Erfindung wird eine induktive Annäherungssensoreinheit zum Erfassen eines Erfassungskörpers mit metallischen Eigenschaften bereitgestellt, aufweisend eine mit einzelnen zeitlich voneinander beabstandeten pulsförmigen Signalen beaufschlagte Sensorspule, eine Auswerteeinheit.

Die Auswerteeinheit ist ausgebildet, Werte für Spannung oder Strom des pulsförmigen Signals an mehreren Abtastzeitpunkten zu messen und aus den gemessenen Werten ein Ist-Zeitreihensignal zu ermitteln.

Die Annäherungssensoreinheit weist außerdem eine Speichereinheit auf, wobei in der Speichereinheit für den Erfassungskörper wenigstens drei Werte eines Referenz-Zeitreihensignals abgespeichert sind.

Die Auswerteeinheit ist dazu ausgebildet, mittels einer Ermittlung eines funktionalen Zusammenhangs zwischen dem Ist-Zeitreihensignal und dem Referenz-Zeitreihensignal das Ist-Zeitreihensignal auf eine Störung zu prüfen.

Die Auswerteeinheit ist ausgebildet, die Störung aus der Linearität eines Streudiagramms zu ermitteln und als Maß für die Linearität entweder ein Bravais-Pearson-Korrelationskoeffizient zu bilden oder das Streudiagramm mit einer Ausgleichsgerade mittels der Methode der kleinsten Quadrate zu nähern.

Gemäß einem weiteren Gegenstand der Erfindung wird ein Verfahren zur Störungsprüfung bei einer induktiven Annäherungssensoreinheit bereitgestellt, wobei die induktive Annäherungssensoreinheit vorzugsweise ausgelegt ist, metallische Eigenschaften eines Erfassungskörpers erfassen.

Die Annäherungssensoreinheit weist eine Sensorspule, eine Ansteuerschaltung, eine Empfangsschaltung, und eine Auswerteeinheit auf.

Mittels der Ansteuerschaltung wird an der Sensorspule ein pulsförmiges Anregungssignal angelegt.

Des Weiteren werden mittels der Ansteuerschaltung Werte für die Spannung oder den Strom an mehreren Abtastzeitpunkten gemessen.

Von der Auswerteeinheit wird aus den gemessenen Werten ein Ist-Zeitreihensignal ermittelt.

Des Weiteren ist eine Speichereinheit vorgesehen, wobei in der Speichereinheit für den Erfassungskörper wenigstens drei Werte eines Referenz-Zeitreihensignals und / oder ein Referenzverlauf eines Anregungssignals abgespeichert werden.

Mittels der Auswerteeinheit wird aus einem Vergleich des Ist-Zeitreihensignals mit dem Referenz-Zeitreihensignal das Ist-Zeitreihensignal auf eine Störung geprüft, wobei die Störung anhand der Linearität eines Streudiagramms ermittelt wird und als Maß für die Linearität entweder ein Bravais-Pearson-Korrelationskoeffizient gebildet wird oder das Streudiagramm mit einer Ausgleichsgerade mittels der Methode der kleinsten Quadrate genähert wird.

Eine induktive Annäherungssensoreinheit beruht unter anderem auf einer Erfassung von einer Änderung der Induktivität bzw. der Güte der Sensorspule bei Annäherung des metallischen Erfassungskörpers.

Die Sensorspule wird mittels einzelner Strompulse, also einzelner zeitlich voneinander beabstandeter pulsförmiger Signale angeregt, so dass das von der Spule erzeugte Magnetfeld ab einem ausreichend geringen Abstand des sich nähernden Erfassungskörpers Wirbelströme in dem Erfassungskörper induziert. Durch eine Rückwirkung nach dem Trafoprinzip wird in der Sensorspule das Abklingverhalten verändert.

Nach dem Ende des Strompulses, z.B. durch Trennen von der Stromquelle, wird das Abklingen der induzierten Wirbelströme mit der Sensorspule erfasst, wobei das Abklingen der Wirbelströme von dem Abklingen eines Selbstinduktions-Spannungspulses überlagert wird.

Anhand der Überlagerung, d.h. aus der Abweichung des Sensorspulensignals von dem Abklingverhalten des Selbstinduktions-Spannungspulses ohne die Induktion des Erfassungskörpers, lässt sich die Anwesenheit des Erfassungskörpers und / oder der Abstand und / oder zumindest das Erreichen des Schaltabstands ermitteln.

Das Abklingverhalten, auch Impulsantwort genannt, wird beispielsweise durch Abgreifen der Spannung an den beiden Enden der Sensorspule erfasst bzw. abgetastet. Die Spannungs- oder Stromwerte werden zu mehreren Abtastzeitpunkten mittels der Auswerteeinheit als Ist-Zeitreihensignal erfasst.

Die Auswerteeinheit ist außerdem dazu ausgelegt, das Ist-Zeitreihensignal mit einem hinterlegten Referenz-Zeitreihensignal funktional zu verknüpfen bzw. einen funktionalen Zusammenhang zu ermitteln.

Als Referenz-Zeitreihensignal wird ein durch Abtasten der Impulsantwort der Sensorspule für einen Referenz-Erfassungskörper mit einem bekannten Material und in einem festen, gegebenenfalls bekannten Abstand bezeichnet.

Der funktionale Zusammenhang liefert Informationen über Störungen, z.B. durch Abweichen von einem typischen Verlauf eines funktionalen Zusammenhangs.

Eine Störung wird beispielsweise durch Vergleich des funktionalen Zusammenhangs, z.B. eines Streudiagramms bzw. einer Auswertekurve, mit einem hinterlegten Referenz-Zusammenhang ermittelt.

Hierfür wird der funktionale Zusammenhang für die gesamte Zeit des Anregungspulses und / oder der Abklingzeit einer Impulsantwort oder für einen oder mehrere Zeitabschnitte des Ist-Zeitreihensignals bzw. des Referenz-Zeitreihensignals betrachtet.

In einer Ausführungsform wird der funktionale Zusammenhang durch das Verknüpfen von mindestens drei Werten $x_1$, $x_2$, $x_3$ des Ist-Zeitreihensignals mit drei zeitlich im Hinblick auf das pulsförmige Anregungssignal entsprechenden Werten $y_1$, $y_2$, $y_3$ des Referenz-Zeitreihensignals geprüft, Die mindestens drei gebildeten Wertepaare ($x_i$, $y_i$) werden im Folgenden auch als Auswertekurve bezeichnet.

Wird die Verknüpfung graphisch dargestellt, d.h. das Ist-Zeitreihensignals wird gegen das Referenz-Zeitreihensignals aufgetragen, entspricht beispielsweise die Abszissenachse der Referenz-Zeitreihe und die Ordinatenachse der Ist-Zeitreihe. Die sich in diesem Koordinatensystem ergebende Auswertekurve stellt ein Teil eines sogenannten Streudiagramms dar.

Die Auswertekurve weist über den gesamten Verlauf des Ist-Zeitreihensignals bzw. des Referenz-Zeitreihensignals einen charakteristischen, den funktionalen Zusammenhang wiedergebenden Verlauf auf. Für die beschriebene Ausführungsform ist der funktionale Zusammenhang typischerweise linear, d.h. die Auswertekurve weist einen linearen oder zumindest im Wesentlichen linearen Verlauf mit einer typischerweise positiven Steigung auf.

Eine Abweichung des funktionalen Zusammenhangs von dem typischen Verlauf weist auf eine Störung des Ist-Zeitreihensignals bzw. eine dem Ist-Zeitreihensignal anhaftende Störung hin, was bedeutet, dass eine Abweichung von dem linearen Verlauf bzw. der Linearität auf eine Störung hinweist.

Es versteht sich, dass auch andere funktionale Zusammenhänge bildbar sind. Werden beispielsweise Wertepaare aus Ist-Zeitreihensignalwerten und quadrierten Referenz-Zeitreihensignalen gebildet, so ergibt sich entsprechend ein quadratischer Anstieg der Auswertekurve bzw. ein quadratischer Verlauf als funktionaler Zusammenhang.

Um die Linearität zu bestimmten, d.h. ein Maß für die Störung zu erhalten, ist kein besonders großer rechnerischer Aufwand notwendig. Beispielsweise wird das Streudiagramm, also die Auswertekurve mit einer Ausgleichsgeraden $y = y_0 + a \cdot x$ genähert, z.B. mittels der Methode der kleinsten Quadrate, so dass sich a wie folgt ergibt:

$$a = \frac{\sum_{i=1}^{N}(x_i - \bar{x}) \cdot (y_i - \bar{y})}{\sum_{i=1}^{N}(x_i - \bar{x})^2} \quad ,$$

wobei x und y jeweils die Mittelwerte aller N Werte des Ist- bzw. Referenz-Zeitreihensignals sind.

Eine Abweichung der Auswertekurve von der ermittelten Ausgleichsgeraden stellt ein Maß für die Linearität der Auswertekurve dar. Die Abweichung wird beispielsweise durch eine mittlere Summe der quadratischen Abweichungen der die Auswertekurve bildenden Wertepaare von Ist- und Referenz-Zeitreihensignal von der Ausgleichsgeraden dargestellt:

$$\frac{1}{N}\sum_{i=1}^{N}(y_i - y_0 - a \cdot x_i)^2$$

Gemäß einer alternativen Ausführungsform wird ein Bravais-Pearson-Korrelationskoeffizient gebildet, z. B. als

$$\rho = a \cdot \frac{\sigma_x}{\sigma_y} = \frac{\sum_{i=1}^{N}(x_i - \bar{x}) \cdot (y_i - \bar{y})}{\sqrt{\sum_{i=1}^{N}(x_i - \bar{x})^2 \sum_{i=1}^{N}(y_i - \bar{y})^2}} \rho \epsilon [-1, 1]$$

wobei

$$\sigma_x = \sqrt{\sum_{i=1}^{N} \frac{(x_i - \bar{x})^2}{N}} \quad \text{und} \quad \sigma_x = \sqrt{\sum_{i=1}^{N} \frac{(x_i - \bar{x})^2}{N}}$$

Der entsprechend gebildete Korrelationskoeffizient ist bei negativer Steigung der Auswertekurve negativ und bei einer positiven Steigung der Auswertekurve positiv. Nimmt der Korrelationskoeffizient den Wert 1 bzw. -1 an, so korrelieren die Wertepaare aus Ist- und Referenz-Zeitreihensignal quasi perfekt bzw. der Zusammenhang zwischen Ist- und Referenz-Zeitreihensignal ist linear. Der Korrelationskoeffizient bzw. dessen Abweichung von dem Wert |1| stellt somit in diesem Fall das Maß für die Linearität der Auswertekurve dar.

Mittels der Verknüpfung des Ist-Zeitreihensignals mit einem Referenz-Zeitreihensignal wird somit, z.B. mittels der vorbeschriebenen Ausführungsformen, aufgrund der aus der Verknüpfung hervorgehenden Auswertekurve festgestellt, ob das Ist-Zeitreihensignal eine Störung aufweist oder nicht.

So kann der Abstand eindeutig einer entsprechenden hinterlegten materialspezifischen Verknüpfung von Sensorspulenspannung und Abstand entnommen oder jedem anderen den materialspezifischen Abstand liefernden Zusammenhang entnommen werden.

Der funktionale Zusammenhang zwischen dem Ist-Zeitreihensignal und dem Referenz-Zeitreihensignal stellt einen sehr einfachen und zuverlässigen Weg dar, Störungen zu ermitteln. Ein Vorteil der Annäherungssensoreinheit ist daher, die hohe Zuverlässigkeit und geringe Reaktionszeit bei gleichzeitig geringen Anforderungen an die Auswerteeinheit.

In einer Weiterbildung ist die Auswerteeinheit ausgebildet, aus einem Vergleich eines Anregungssignals, z.B. des Anregungsstromverlaufs oder des Anregungsspannungsverlaufs, mit einem Referenzverlauf den Verlauf des Anregungssignals auf eine Störung zu prüfen.

Gemäß einer ersten Ausführungsform ist die Auswerteeinheit ausgebildet, bei Vorliegen einer Störung das mit einer Störung beaufschlagte Ist-Zeitreihensignal zu unterdrücken und / oder ein Fehlersignal auszugeben. Das Fehlersignal kann beispielsweise optisch oder akustisch ausgegeben oder an eine übergeordnete Steuereinheit oder ähnliches weitergegeben werden.

Gemäß einer anderen Ausführungsform ist die Auswerteeinheit ausgebildet, bei einer Störung aus dem Ist-Zeitreihensignal kein Objektabstand bzw. keine Objekteigenschaft des Erfassungskörpers zu ermitteln. So wird verhindert, dass die Annäherungssensoreinheit fehlerhafte Schaltsignale bzw. Ausgangssignale ausgibt.

In einer weiteren Ausführungsform ist die Auswerteeinheit ausgebildet, ein Teil des Ist-Zeitreihensignals oder mehrere Teile des Ist-Zeitreihensignals oder das vollständige Ist-Zeitreihensignal auf eine Störung zu überprüfen.

Gemäß einer anderen Weiterbildung ist die Auswerteeinheit ausgebildet, bei einer Störung die Größe des zu untersuchenden Teils des Ist-Zeitreihensignals zu verändern. Anhand des ermittelten funktionalen Zusammenhangs ist beispielsweise auch feststellbar, ob eine Störung nur einen Teil des Ist-Zeitreihensignals betrifft. Entsprechend kann aufgrund einer solchen lokalen Störung eine Auswertung des Ist-Zeitreihensignals auf einen anderen, nicht von der Störung betroffenen Teil des Ist-Zeitreihensignals eingeschränkt werden.

In einer weiteren Weiterbildung ist die Auswerteeinheit ausgebildet, die Störungsprüfung mittels einer Auswertung des Spannungsverlaufs und / oder des Stromverlaufs des Anregungssignals und / oder des Ist-Zeitreihensignals durchzuführen. Auch der Spannungsverlauf bzw. der Stromverlauf der Sensorspule weisen gegebenenfalls Hinweise auf Störungen auf, die z.B. zusätzlich zu dem Ist-Zeitreihensignal für die Prüfung auf Störungen herangezogen werden.

In einer anderen Ausführungsform ist die Auswerteeinheit ausgebildet, die Störung aus der Linearität eines Streudiagramms zu ermitteln.

In einer weiteren Ausführungsform ist die Auswerteeinheit ausgebildet, als Maß für die Linearität ein Bravais-Pearson-Korrelationskoeffizient zu bilden.

In einer anderen Weiterbildung entsprechen die Abtastzeitpunkte des Ist-Zeitreihensignals den Abtastzeitpunkten des Soll-Zeitreihensignals oder sind genau gleich oder interpoliert.

In einer weiteren Weiterbildung ist die Speichereinheit ausgebildet, das Auftreten von Störungen abzuspeichern und die Anzahl von Störungen zu erfassen. So können die Störungen beispielsweise bei einer Wartung der Sensoreinheit ausgelesen werden.

In einer ersten Ausführungsform des Verfahrens zur Störungsprüfung wird bei Vorliegen einer Störung das mit einer Störung beaufschlagte Ist-Zeitreihensignal unterdrückt wird und / oder ein Fehlersignal ausgegeben.

In einer weiteren Ausführungsform wird mittels der Auswerteeinheit bei Vorliegen einer Störung aus dem mit einer Störung beaufschlagten Ist-Zeitreihensignal kein Objektabstand oder keine Objekteigenschaft des Erfassungskörpers ermittelt und / oder ein Fehlersignal ausgegeben.

In einer anderen Ausführungsform wird ein Teil des Ist-Zeitreihensignals oder mehrere Teile des Ist-Zeitreihensignals oder das vollständige Ist-Zeitreihensignal auf eine Störung überprüft.

In weiteren Ausführungsformen wird bei einer Störung die Größe des zu untersuchenden Teils des Ist-Zeitreihensignals verändert, z.B. auf einen Störungsfreien Bereich eingeschränkt.

In einer anderen Weiterbildung wird die Störungsprüfung mittels einer Auswertung des Spannungsverlaufs und / oder des Stromverlaufs des Anregungssignals und / oder des Ist-Zeitreihensignals durchgeführt.

In einer weiteren Weiterbildung wird die Störung anhand der Linearität eines Streudiagramms ermittelt.

In einer anderen Ausführungsform wird als Maß für die Linearität ein Bravais-Pearson-Korrelationskoeffizient gebildet.

In einer weiteren Weiterbildung werden die Abtastzeitpunkte des Ist-Zeitreihensignals entsprechend den Abtastzeitpunkten des Soll-Zeitreihensignals gewählt oder die Abtastzeitpunkte des Ist-Zeitreihensignals werden genau gleich gewählt wie die Abtastzeitpunkte des Referenz-Zeitreihensignals oder interpoliert.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die

Figur 1      eine Ansicht auf eine erste Ausführungsform einer induktiven Annäherungssensoreinheit,

Figur 2      einen beispielhaften Verlauf einer Schalt- und einer Sensorspulenspannung,

Figur 3      mehrere Impulsantwortsignale und entsprechende Auswertekurven zur Störungsprüfung.

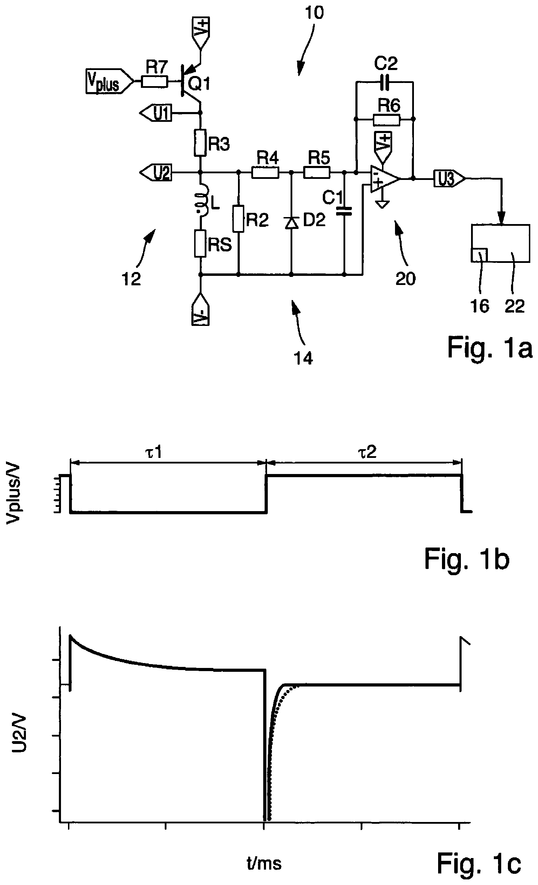

Die Abbildung der Figur 1 zeigt eine erste Ausführungsform einer induktiven Annäherungseinheit 10 zum Erfassen eines Erfassungskörpers mit einer Sensorspule 12, einer Auswerteeinheit 14 und einer Speichereinheit 16 dargestellt.

Die Sensorspule 12 weist eine Induktivität L und einen Wirkwiderstand $R_S$ auf und wird über einen Transistor Q1 und einen Widerstand R3 immer abwechselnd für ein Zeitintervall $T_1$ mit einer Spannungsquelle V+ als pulsförmiges Signal verbunden und für ein sich anschließendes Zeitintervall $T_2$ mittels des Transistors Q1 wieder von der Spannungsquelle V+ getrennt, so dass die pulsförmigen Signale jeweils zeitlich voneinander beabstandet sind. Die Steuerspannung $V_{puls}$ des Transistors Q1 ist in Abschnitt b der Figur 1 dargestellt.

Nach dem Trennen der Sensorspule 12 von der Spannungsquelle V+ führt die Selbstinduktion der Sensorspule 16 zu einem Selbstinduktions-Spannungspuls. Ein entsprechender Verlauf der aus der Selbstinduktion stammenden Spannung $U_2$ der Sensorspule 16 ist in Abschnitt c der Figur 1 als durchgezogene Linie dargestellt.

Befindet sich der metallische Erfassungskörper in der Nähe der Sensoreinheit 10, so erzeugen die in dem Erfassungskörper induzierten Wirbelströme eine Spannungspulsantwort in der Sensorspule 16, die jedoch den Selbstinduktions-Spannungspuls überlagert ist. Der zeitliche Verlauf der aus der Überlagerung von Selbstinduktion und Spannungspulsantwort stammenden Spannung $U_2$ an der Sensorspule 12 ist in Abschnitt c der Figur 1 als gestrichelte Linie dargestellt.

In dem dargestellten Ausführungsbeispiel weist die Sensoreinheit 10 außerdem einen Bedämpfungswiderstand R4, um insbesondere die Höhe des Selbstinduktionspulses zu reduzieren, eine die Spulenspannung limitierende Diode D2 und eine Verstärkungsschaltung 20 als Teil der Auswerteeinheit 14 auf.

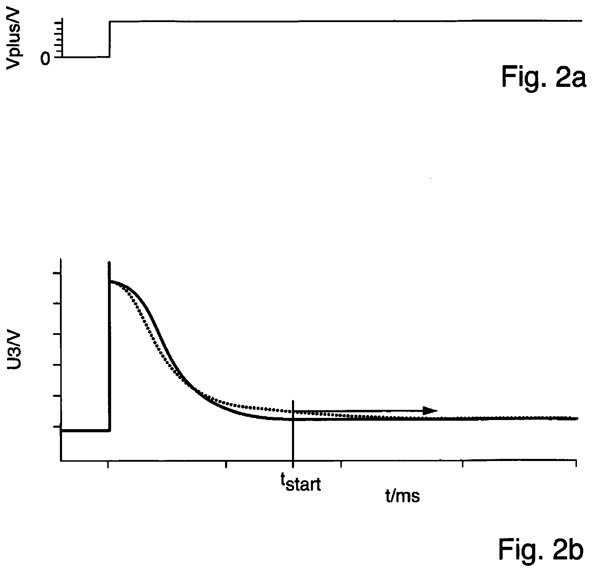

Eine nach der Verstärkungsschaltung 20 abgreifbare Spannung $U_3$ der Sensorspule 16 ist in der Abbildung der Figur 2 (unten) zusammen mit dem Steuersignal des Transistors Q1 (oben) dargestellt. Der Unterschied der Spannungsverläufe mit (gestrichelt) und ohne (durchgezogenen Linie) metallischen Erfassungskörper ist zu erkennen.

Der Zeitpunkt $t_{start}$ zeigt beispielhaft einen Anfangszeitpunkt für ein Abtasten des Verlaufs der Spannung $U_3$, um den Abstand des Objekts zu ermitteln. Im dargestellten Ausführungsbeispiel ist der Zeitpunkt $t_{start}$ so gewählt, dass der durch die Selbstinduktion erzeugte Spannungsimpuls bereits weitestgehend abgeklungen ist.

Für die weitere Auswertung weist die Auswerteeinheit 14 außerdem eine Recheneinheit 22 mit einer Speichereinheit 16 auf.

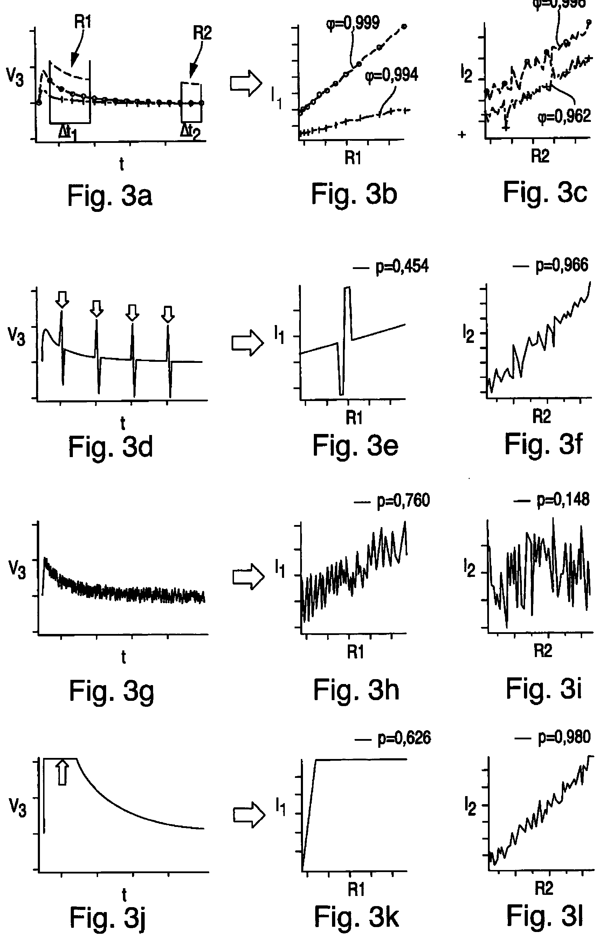

In der Abbildung der Figur 3 sind unterschiedliche gemessene Impulsantwortsignale, also die Ist-Zeitreihensignale und jeweils dazugehörige Auswertekurven dargestellt. Die Ist-Zeitreihensignale sind in der linken Spalte dargestellt, also in den Abschnitten a, d, g und j. In der mittleren Spalte ist jeweils eine dazugehörige, auf einem ersten

Zeitintervall $\Delta$t1 beruhende Auswertekurve dargestellt und in der rechten Spalte eine entsprechende auf dem Zeitintervall $\Delta$t2 beruhende Auswertekurve.

In den Abbildungen der Abschnitte a, b und c sind störungsfreie Ist-Zeitreihensignale sowie entsprechende Auswertekurven dargestellt, wobei die mit Kreisen gekennzeichnete Kurven das Messergebnis mit einem in der Nähe befindlichen Abstandskörper wiedergeben während die mit Kreuzen gekennzeichneten Kurven das Messergebnis ohne einen Erfassungskörper wiedergeben.

In der Abbildung in Abschnitt a sind außerdem die beiden Zeitintervalle $\Delta$t1 und $\Delta$t2 dargestellt. Das erste Zeitintervall $\Delta$t1 erfasst einen Zeitraum des ersten starken Abfalls bzw. Abklingens der Impulsantwort. Das zweite Zeitintervall $\Delta$t2 erfasst einen Bereich, in dem die Impulsantwort bzw. das Ist-Zeitreihensignal bereits im Wesentlichen abgeklungen ist.

Für die beiden Zeitintervalle $\Delta$t1 und $\Delta$t2 sind auch jeweils noch Referenzkurven eingezeichnet (gestrichelt). Aus einem Vergleich des Ist-Zeitreihensignals mit den Referenzkurven lassen sich Hinweise auf eine Störung ableiten.

In Abschnitt b ist jeweils der Ist-Zeitreihensignalabschnitt I1 für das erste Zeitintervall $\Delta$t1 gegen einen entsprechenden Referenz-Zeitreihensignalabschnitt R1 aufgetragen. Das sich ergebende Streudiagramm wird auch als Auswertekurve bezeichnet. Die Auswertekurve stellt in diesem Ausführungsbeispiel den funktionalen Zusammenhang zwischen dem Ist-Zeitreihensignal und dem Referenz-Zeitreihensignal dar.

Wie zu erkennen ist, ist der funktionale Zusammenhang linear, d.h. die Auswertekurve weist jeweils einen linearen oder zumindest im Wesentlichen linearen Verlauf mit einer positiven Steigung auf. Die beiden Auswertekurven mit und ohne Erfassungskörper unterscheiden sich lediglich hinsichtlich der Steigung.

Auch die in Abschnitt c dargestellte entsprechende Auswertekurve für das zweite Zeitintervall $\Delta$t2 bzw. den Ist-Zeitreihensignalabschnitt I2 und den Referenz-Zeitreihensignalabschnitt R2 weist einen im Wesentlichen linear ansteigenden Verlauf auf.

Zur Analyse der Linearität der Auswertekurven wird in den dargestellten Ausführungsbeispielen jeweils ein Bravais-Pearson-Korrelationskoeffizient $\rho$ bestimmt, wobei Werte zwischen 0,9 und 1 einen hohen Grad an Linearität anzeigen.

In der zweiten Zeile der Figur 3, also den Abschnitten d, e und f sind das Ist-Zeitreihensignal sowie die Auswertekurven für die beiden Zeitintervalle $\Delta$t1 und $\Delta$t2 bei Vorliegen einer periodisch widerkehrenden burst-artigen Störung dargestellt. In dem Ist-Zeitreihensignal in Abschnitt d ist die Störung deutlich anhand von periodisch auftretenden Sprüngen zu erkennen.

Auch in dem Auswertesignal für das erste Zeitintervall $\Delta$t1 ist die Störung deutlich zu erkennen und schlägt sich auch in einem sehr niedrigen Wert des Bravais-Pearson-Korrelationskoeffizienten $\rho$ nieder.

In dem Auswertesignal für das zweite Zeitintervall $\Delta$t2 ist die Störung dahingegen nicht zu erkennen. Dieses verläuft linear und der Bravais-Pearson-Korrelationskoeffizient $\rho$ weist einen entsprechend hohen Wert auf.

Das Ausführungsbeispiel der zweiten Zeile verdeutlicht somit, dass es vorteilhaft ist, mehrere Zeitabschnitte des Ist-Zeitreihensignals für die Ermittlung des funktionalen Zusammenhangs zu dem Referenz-Zeitreihensignal heranzuziehen, um sicher zu stellen, dass eine Störung erfasst wird.

Andererseits kann das Auswerten verschiedener Zeitintervalle helfen ein störungsfreies Zeitintervall zu ermitteln, so dass die Auswertung, also die Abstandsbestimmung, auf das störungsfreie Zeitintervall eingeschränkt werden kann.

Das in Abschnitt g gezeigte Ist-Zeitreihensignal weist ein breitbandiges Rauschen als Störung auf. Die für dieses Ist-Zeitreihensignal ermittelten Auswertekurven weisen für beide Zeitintervalle $\Delta$t1 und $\Delta$t2 eine deutliche Abweichung von einem Linearen verlauf bzw. relativ bis sehr niedrige Werte des Bravais-Pearson-Korrelationskoeffizienten $\rho$ auf.

In der Abbildung des Abschnitts j ist ein bei gesättigter Signalelektronik erfasstes Ist-Zeitreihensignal dargestellt. Wie bei dem Ausführungsbeispiel der zweiten Zeile der Figur 3 weist die Auswertekurve für das erste Zeitintervall $\Delta$t1 eine sehr niedrige Linearität auf, während die Linearität im zweiten Zeitintervall $\Delta$t2 sehr hoch ist.

## Patentansprüche

1. Induktive Annäherungssensoreinheit (10) zum Erfassen eines Erfassungskörpers, wobei der Erfassungskörper metallische Eigenschaften aufweist, umfassend

- eine mit einzelnen zeitlich voneinander beabstandeten pulsförmigen Signalen beaufschlagte Sensorspule (12),
- eine Auswerteeinheit (14), wobei die Auswerteeinheit (14) ausgebildet ist, Werte für Spannung ($U_2$) oder Strom der Sensorspule (12) zu mehreren Abtastzeitpunkten zu messen und aus den gemessenen Werten ein Ist-Zeitreihensignal (I1, I2) zu ermitteln,
- eine Speichereinheit (16), wobei in der Speichereinheit (16) für den Erfassungskörper wenigstens drei Werte eines Referenz-Zeitreihensignals (R1, R2) abgespeichert sind, wobei

- die Auswerteeinheit (14) ausgebildet ist, mittels einer Ermittlung eines funktionalen Zusammenhangs zwischen dem Ist-Zeitreihensignal (I1, I2) und dem Referenz-Zeitreihensignal (R1, R2) das Ist-Zeitreihensignal (I1,I2) auf eine Störung zu prüfen,

**dadurch gekennzeichnet, dass**

- die Auswerteeinheit (14) ausgebildet ist, die Störung aus der Linearität eines Streudiagramms zu ermitteln, und
- die Auswerteeinheit (14) ausgebildet ist, als Maß für die Linearität entweder
- ein Bravais-Pearson-Korrelationskoeffizient (ρ) zu bilden, oder
- das Streudiagramm mit einer Ausgleichsgerade mittels der Methode der kleinsten Quadrate zu nähern.

2. Induktive Annäherungssensoreinheit (10) nach Anspruch 1, **dadurch gekennzeichnet, dass** die Auswerteeinheit (14) ausgebildet ist, bei Vorliegen einer Störung das mit einer Störung beaufschlagte Ist-Zeitreihensignal (I1, I2) zu unterdrücken und / oder ein Fehlersignal auszugeben.

3. Induktive Annäherungssensoreinheit (10) nach Anspruch 1 oder Anspruch 2, **dadurch gekennzeichnet, dass** die Auswerteeinheit (14) ausgebildet ist, ein Teil des Ist-Zeitreihensignals (I1, I2) oder mehrere Teile des Ist-Zeitreihensignals (I1, I2) oder das vollständige Ist-Zeitreihensignal auf eine Störung zu überprüfen.

4. Induktive Annäherungssensoreinheit (10) nach einem der vorangegangenen Ansprüche, **dadurch gekennzeichnet, dass** die Speichereinheit (16) ausgebildet ist, das Auftreten von Störungen abzuspeichern und die Anzahl von Störungen zu erfassen.

5. Verfahren zur Störungsprüfung bei einer induktiven Annäherungssensoreinheit (10), wobei

- die Annäherungssensoreinheit (10) eine Sensorspule (12), eine Ansteuerschaltung, eine Empfangsschaltung, und eine Auswerteeinheit (14) aufweist,
- der Sensorspule (12) ein pulsförmiges Signal zugeführt wird,
- Werte für die Spannung oder den Strom der Sensorspule (12) zu mehreren Abtastzeitpunkten als Impulsantwort gemessen werden,
- von der Auswerteeinheit (14) aus den gemessenen Werten der Impulsantwort ein Ist-Zeitreihensignal ermittelt wird,
- in der Speichereinheit (16) für den Erfassungskörper wenigstens drei Werte eines Referenz-Zeitreihensignals und / oder ein Referenzverlauf eines Anregungssignals abgespeichert werden, wobei
- mittels der Auswerteeinheit (14) aus einem Vergleich des Ist-Zeitreihensignals mit dem Referenz-Zeitreihensignal das Ist-Zeitreihensignal auf eine Störung geprüft wird,

**dadurch gekennzeichnet, dass**

- mittels der Auswerteeinheit (14) die Störung anhand der Linearität eines Streudiagramms ermittelt wird, wobei
- mittels der Auswerteeinheit (14) als Maß für die Linearität entweder
- ein Bravais-Pearson-Korrelationskoeffizient gebildet wird, oder
- mittels der Auswerteeinheit (14) das Streudiagramm mit einer Ausgleichsgerade mittels der Methode der kleinsten Quadrate zu nähern.

6. Verfahren zur Störungsprüfung bei einer induktiven Annäherungssensoreinheit (10) nach Anspruch 5, **dadurch gekennzeichnet, dass** mittels der Auswerteeinheit (14) bei Vorliegen einer Störung aus dem mit einer Störung beaufschlagten Ist-Zeitreihensignal kein Objektabstand oder keine Objekteigenschaft des Erfassungskörpers ermittelt wird und / oder ein Fehlersignal ausgegeben wird.

7. Verfahren zur Störungsprüfung bei einer induktiven Annäherungssensoreinheit (10) nach einem der Ansprüche 5 oder 6, **dadurch gekennzeichnet, dass** ein Teil des Ist-Zeitreihensignals oder mehrere Teile des Ist-Zeitreihensignals oder das vollständige Ist-Zeitreihensignal auf eine Störung überprüft werden.

**Claims**

1. Inductive proximity sensor unit (10) for detecting a detection body, wherein the detection body has metallic properties, comprising

- a sensor coil (12) which is acted on by individual pulse-shaped signals mutually spaced in time,
- an evaluating unit (14), wherein the evaluating unit (14) is configured to measure values for voltage ($U_2$) or

current of the sensor coil (12) at a plurality of scanning intervals and to determine an actual time series signal (I1, I2) from the measured values,

- a memory unit (16), wherein at least three values of a reference time series signal (R1, R2) for the detection body are stored in the memory unit 916), wherein

- the evaluating unit (14) is configured to check the actual time series signal (I1, I2) for a disturbance by means of determination of a functional correlation between the actual time series signal (I1, I2) and the reference time series signal (R1, R2),

**characterised in that**

- the evaluating unit (14) is configured to determine the disturbance from the linearity of a scatter diagram and
- the evaluating unit (14) is configured to either

  - form a Bravais-Pearson correlation coefficient (p) or
  - approximate the scatter diagram with a mean straight line by way of the method of least squares

as measure for the linearity.

2. Inductive proximity sensor unit (10) according to claim 1, **characterised in that** the evaluating unit (14) is configured to suppress the actual time series signal (I1, I2), which is acted on by a disturbance, and/or issue a fault signal when a disturbance is present.

3. Inductive proximity sensor unit (10) according to claim 1 or claim 2, **characterised in that** the evaluating unit (14) is configured to check a part of the actual time series signal (I1, I2) or a plurality of parts of the actual time series signal (I1, I2) or the entire actual time signal for a disturbance.

4. Inductive proximity sensor unit (10) according to any one of the preceding claims, **characterised in that** the memory unit (16) is configured to store the occurrence of disturbances and to detect the number of disturbances.

5. Method for checking disturbance in an inductive proximity sensor unit (10), wherein

  - the proximity sensor unit (10) comprises a sensor coil (12), an activation circuit, a reception circuit and an evaluating unit (14),
  - a pulse-shaped signal is fed to the sensor coil (12),
  - values for the voltage or current of the sensor coil (12) are measured as a pulse response at a plurality of scanning intervals,
  - an actual time series signal is determined by the evaluating unit (14) from the measured values of the pulse response,
  - at least three values of a reference time series signal and/or a reference plot of an excitation signal for the detection body are stored in the memory unit (16), wherein
  - the actual time series signal is checked for a disturbance by means of the evaluating unit (14) from a comparison of the actual time series signal with the reference time series signal,

**characterised in that**

  - the disturbance is determined on the basis of the linearity of a scatter diagram by means of the evaluating unit (14), wherein

    - a Bravais-Person correlation coefficient is formed or
    - the scatter diagram is approximated with a mean straight line by way of the method of least squares

by means of the evaluating unit (14) as a measure for the linearity.

6. Method for checking for disturbance in an inductive proximity sensor unit (10) according to claim 5, **characterised in that** no object distance or no object property of the detection body is determined and/or a fault signal is issued from the actual time series signal, which is acted on by a disturbance, by means of the evaluating unit (14) when a disturbance is present.

7. Method of checking for disturbance in an inductive proximity sensor unit (10) according to one of claims 5 and 6, **characterised in that** a part of the actual time series signal or a plurality of parts f the actual time series signal or the entire actual time series signal is checked for a disturbance.

**Revendications**

1. Unité de capteur de proximité inductif (10) pour détecter un corps de détection, le corps de détection présentant des propriétés métalliques, comprenant

   - une bobine de capteur (12) soumise à des signaux impulsionnels individuels espacés dans le temps,
   - une unité d'évaluation (14), l'unité d'évaluation (14) étant conçue pour mesurer des valeurs de tension ($U_2$) ou de courant de la bobine de capteur (12) à plusieurs instants d'échantillonnage et pour déterminer à partir des valeurs mesurées un signal série temporel réel (I1, I2),
   - une unité de mémoire (16), dans laquelle pour le corps de détection au moins trois valeurs d'un signal série temporel de référence (R1, R2) sont mémorisées, et
   - l'unité d'évaluation (14) étant conçue pour vérifier le signal temporel réel (I1, I2) pour une perturbation au moyen d'une détermination d'une relation fonctionnelle entre le signal temporel réel (I1, I2) et le signal série temporel de référence (R1, R2), **caractérisé en ce que**
   - l'unité d'évaluation (14) est conçue pour déterminer la perturbation à partir de la linéarité d'un diagramme de dispersion, et
   - l'unité d'évaluation (14) est conçue pour, comme mesure de la linéarité, soit
   - former un coefficient de corrélation de Bravais-Pearson ($\rho$), soit
   - approcher le diagramme de dispersion par une droite d'ajustement au moyen de la méthode des moindres carrés.

2. Unité de capteur de proximité inductif (10) selon la revendication 1, **caractérisée en ce que** l'unité d'évaluation (14) est conçue pour, en présence d'une perturbation, supprimer le signal série temporel réel (I1, I2) soumis à une perturbation et / ou émettre un signal d'erreur.

3. Unité de capteur de proximité inductif (10) selon la revendication 1 ou la revendication 2, **caractérisée en ce que** l'unité d'évaluation (14) est conçue pour vérifier une partie du signal série temporel réel (I1, I2) ou plusieurs parties du signal série temporel réel (I1, I2) ou le signal série temporel réel complet pour une perturbation.

4. Unité de capteur de proximité inductif (10) selon l'une des revendications précédentes, **caractérisée en ce que** l'unité de mémoire (16) est conçue pour mémoriser l'apparition de perturbations et détecter le nombre de perturbations.

5. Procédé de vérification de perturbation pour une unité de capteur de proximité inductif (10), dans lequel

   - l'unité de capteur de proximité (10) comporte une bobine de capteur (12), un circuit de commande, un circuit de réception et une unité d'évaluation (14),
   - un signal impulsionnel est appliqué à la bobine de capteur (12),
   - des valeurs pour la tension ou le courant de la bobine de capteur (12) sont mesurées à plusieurs instants d'échantillonnage comme réponse impulsionnelle,
   - par l'unité d'évaluation (14), un signal série temporel réel est déterminé à partir des valeurs mesurées de la réponse impulsionnelle,
   - dans l'unité de mémoire (16), pour le corps de détection, au moins trois valeurs d'un signal série temporel de référence et/ou un déroulement de référence d'un signal d'excitation sont mémorisés, et
   - au moyen de l'unité d'évaluation (14), à partir d'une comparaison du signal série temporel réel avec le signal série temporel de référence, le signal série temporel réel est vérifié pour une perturbation,
   **caractérisé en ce que**
   - au moyen de l'unité d'évaluation (14), la perturbation est déterminée sur la base de la linéarité d'un diagramme de dispersion, et
   - au moyen de l'unité d'évaluation (14), comme mesure de la linéarité, soit
   - un coefficient de corrélation de Bravais-Pearson est formé, soit
   - au moyen de l'unité d'évaluation (14), le diagramme de dispersion est approché par une droite d'ajustement au moyen de la méthode des moindres carrés.

6. Procédé de vérification de perturbation pour une unité de capteur de proximité inductif (10) selon la revendication 5, **caractérisé en ce que**, au moyen de l'unité d'évaluation (14), en présence d'une perturbation, aucune distance d'objet ou aucune propriété d'objet du corps de détection n'est déterminée à partir du signal série temporel réel soumis à une perturbation et/ou un signal d'erreur est émis.

7. Procédé de vérification de perturbation pour une unité de capteur de proximité inductif (10) selon l'une des revendications 5 ou 6, **caractérisé en ce qu'**une partie du signal série temporel réel ou plusieurs parties du signal série temporel réel ou le signal série temporel réel complet sont vérifiés pour une perturbation.

Fig. 1a

Fig. 1b

Fig. 1c

Fig. 2a

Fig. 2b

Fig. 3a

Fig. 3b

Fig. 3c

Fig. 3d

Fig. 3e

Fig. 3f

Fig. 3g

Fig. 3h

Fig. 3i

Fig. 3j

Fig. 3k

Fig. 3l

**EP 4 030 622 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 106767952 A
- EP 0492029 B1
- DE 102017130122 A1
- DE 19506339 A1
- DE 112013006849 A5
- DE 102018127157 B3
- DE 102011018430 A1
- EP 3531557 A1
- DE 19530987 C1
- DE 102013209805 A1
- DE 102009058549 A1